(19) Europäisches Patentamt / European Patent Office / Office européen des brevets

(11) **EP 4 585 941 B1**

(12) **EUROPEAN PATENT SPECIFICATION**

(45) Date of publication and mention
of the grant of the patent:
**13.05.2026   Bulletin 2026/20**

(21) Application number: **23863503.1**

(22) Date of filing: **06.09.2023**

(51) International Patent Classification (IPC):
*G01R 31/367* (2019.01)   *G01R 31/36* (2020.01)
*G01R 31/392* (2019.01)   *G01R 31/3842* (2019.01)
*G01R 31/389* (2019.01)   *G01R 31/396* (2019.01)

(52) Cooperative Patent Classification (CPC):
**G01R 31/367; G01R 31/36; G01R 31/3646;
G01R 31/3648; G01R 31/3842; G01R 31/389;
G01R 31/392; G01R 31/396;** Y02E 60/10

(86) International application number:
**PCT/KR2023/013351**

(87) International publication number:
**WO 2024/054037 (14.03.2024 Gazette 2024/11)**

(54) **ELECTRONIC DEVICE FOR DETECTING ABNORMALITY OF BATTERY AND OPERATING METHOD OF THE ELECTRONIC DEVICE**

ELEKTRONISCHE VORRICHTUNG ZUR ERKENNUNG VON BATTERIEANOMALIEN UND VERFAHREN ZUM BETRIEB DER ELEKTRONISCHEN VORRICHTUNG

DISPOSITIF ÉLECTRONIQUE POUR DÉTECTER UNE ANOMALIE DE BATTERIE ET PROCÉDÉ DE FONCTIONNEMENT DU DISPOSITIF ÉLECTRONIQUE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority:  **06.09.2022   KR 20220113111**

(43) Date of publication of application:
**16.07.2025   Bulletin 2025/29**

(73) Proprietor: **LG Energy Solution, Ltd.
Seoul 07335 (KR)**

(72) Inventors:
• **KIM, Geum Bee
Daejeon 34122 (KR)**
• **LEE, Hyun Jun
Daejeon 34122 (KR)**

• **SHIN, Jae Wook
Daejeon 34122 (KR)**
• **CHOI, Sung Wook
Daejeon 34122 (KR)**

(74) Representative: **Goddar, Heinz J.
Boehmert & Boehmert
Anwaltspartnerschaft mbB
Pettenkoferstrasse 22
80336 München (DE)**

(56) References cited:
CN-A- 113 109 725     CN-A- 114 945 834
CN-B- 110 895 311     KR-A- 20210 014 003
KR-A- 20210 031 172   KR-A- 20220 011 487
KR-A- 20220 016 799   KR-A- 20220 060 931
KR-B1- 100 680 901

## Description

## [TECHNICAL FIELD]

CROSS-REFERENCE TO RELATED APPLICATION

This application claims priority to and the benefit of Korean Patent Application No. 10-2022-0113111 filed in the Korean Intellectual Property Office on September 6, 2022.

TECHNICAL FIELD

Embodiments disclosed herein relate to an electronic device for detecting abnormality of a battery and an operating method of the electronic device.

## [BACKGROUND ART]

Secondary batteries, which are easy to apply depending on a product group and have electrical characteristics such as high energy density, are generally used not only in portable devices but also in electric vehicles (EV), hybrid electric vehicles (HEV), etc., driven by an electrical drive source.

Types of secondary batteries widely used at the present time include lithium ion batteries, lithium polymer batteries, nickel cadmium batteries, nickel hydrogen batteries, nickel zinc batteries, and so forth. An operating voltage of a unit secondary battery cell, i.e., a unit battery cell, is about 2.5 to 4.5 volts (V). Therefore, when a higher output voltage is required, a battery pack is formed by connecting a plurality of battery cells in series. In addition, a battery pack may be constructed by connecting multiple battery cells in parallel depending on a charge/discharge capacity required for the battery pack. Thus, the number of battery cells included in the battery pack may be set variously depending on a required output voltage or charge/discharge capacity.

Prior art document CN114945834A discloses battery cell abnormality diagnosis involving forming a feature matrix based on acquired battery cell measurements, and decomposing it, i.e., dividing a large matrix into a number of smaller ones.

## [DISCLOSURE]

## [TECHNICAL PROBLEM]

A battery pack may include a plurality of battery cells connected in series and/or in parallel. As a result, even when a battery cell in an abnormal state exists among the plurality of battery cells, it may not be easy to detect abnormality in the battery cell.

Therefore, there is a need for a method for detecting a battery cell in an abnormal state among a plurality of battery cells.

Technical problems of the embodiments disclosed herein are not limited to the above-described technical problems, and other unmentioned technical problems would be clearly understood by one of ordinary skill in the art from the following description.

## [TECHNICAL SOLUTION]

An electronic device according to the invention includes a battery module including a plurality of battery cells, a sensor circuit configured to obtain state values of each of the plurality of battery cells, and a processor configured to obtain values related to states of each of the plurality of cells as input data through the sensor circuit, obtain feature data based on a feature matrix derived from the input data by using a designated matrix decomposition algorithm, and identify whether each of the plurality of cells is abnormal, based on the feature data, in which the feature matrix is a matrix where values of a designated number of major diagonal components among a plurality of diagonal components of a diagonal matrix for the input data are substituted by 0.

According to an embodiment, the designated number may be a minimum number that causes an occupancy of the major diagonal components with respect to a sum of the plurality of diagonal components exceeds a designated value or greater.

According to an embodiment, the input data may be obtained in a designated range of a measurement item, and the measurement item may include at least one of voltage, current, resistance, state of charge (SoC), state of health (SoH), or temperature.

According to an embodiment, when the measurement item is voltage, the designated range may be between 3.9 and 4.1 volts.

According to an embodiment, the input data may be obtained at designated time intervals for a designated time window while the battery module is being charged.

According to an embodiment, the processor may be further configured to identify additional input data based on the input data and obtain the feature data based on the input data and the additional input data.

According to an embodiment, the additional input data may include state values of other cells than the plurality of cells.

According to an embodiment, the additional input data may include previously obtained state values of the plurality of cells.

According to an embodiment, the processor may be further configured to obtain a feature value of each of the plurality of cells based on feature components of each of the plurality of cells included in the feature data and identify a cell having a feature value exceeding a designated reference feature value among the plurality of cells.

According to an embodiment, the electronic device may further include a display, in which the processor is further configured to provide user notification through the display in response to at least one of the plurality of cells being identified as being in an abnormal state.

An operating method of an electronic device according to the invention includes obtaining values related to states of each of a plurality of cells of the electronic device as input data through a sensor circuit of the electronic device, obtaining feature data based on a feature matrix derived from the input data by using a designated matrix decomposition algorithm, and identifying whether each of the plurality of cells is abnormal, based on the feature data, in which the feature matrix is a matrix where values of a designated number of major diagonal components among a plurality of diagonal components of a diagonal matrix for the input data are substituted by 0.

According to an embodiment, the obtaining of the feature data may include identifying reference input data based on the input data and obtaining the feature data based on the input data and the reference input data. the processor may be further configured to identify additional input data based on the input data and obtain the feature data based on the input data and the additional input data.

According to an embodiment, the identifying of whether each of the plurality of batteries is abnormal may include obtaining a feature value of each of the plurality of cells based on feature components of each of the plurality of cells included in the feature data and identifying a cell having a feature value exceeding a designated reference feature value among the plurality of cells.

## [ADVANTAGEOUS EFFECTS]

An electronic device and an operating method thereof according to various embodiments disclosed herein may detect a battery cell in an abnormal state among a plurality of battery cells.

The effects of an electronic device for detecting abnormality of a battery and an operating method of the electronic device according to the disclosure of the present document are not limited to the effects mentioned above, and other effects not mentioned will be clearly understood by those of ordinary skill in the art according to the disclosure of the present document.

## [DESCRIPTION OF DRAWINGS]

FIG. 1 is a block diagram of an electronic device according to an embodiment of the disclosure.

FIG. 2 is a flowchart illustrating operations of an electronic device according to an embodiment of the present disclosure.

FIG. 3A illustrates a graph according to an embodiment of the present disclosure.

FIG. 3B illustrates a graph according to an embodiment of the disclosure; and

FIG. 3C illustrates a graph according to an embodiment of the present invention.

FIG. 3D illustrates a graph according to an embodiment of the present disclosure.

With regard to the description of the drawings, similar reference numerals may be used to refer to similar or related components.

## [MODE FOR INVENTION]

Hereinafter, embodiments of the present disclosure will be described with reference to the accompanying drawings. However, the description is not intended to limit the present disclosure to particular embodiments, and it should be construed as including various modifications and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and " at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

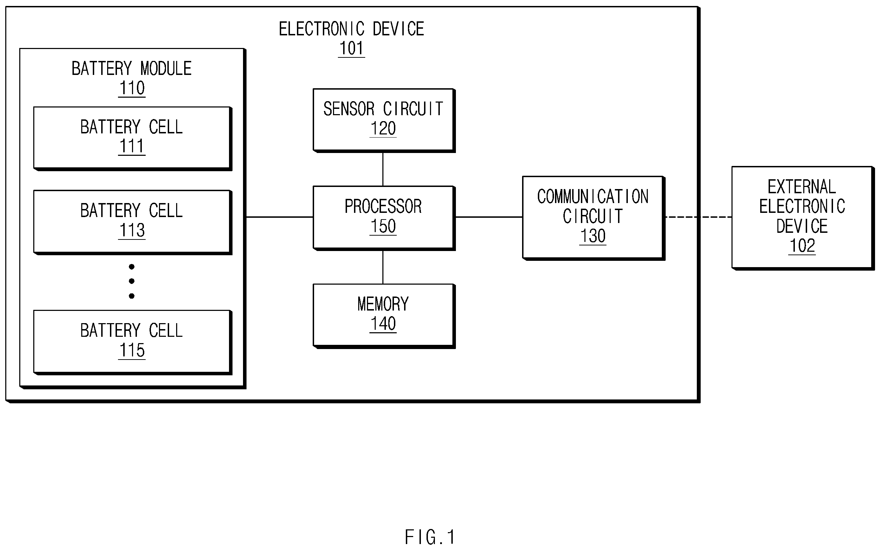

FIG. 1 is a block diagram of an electronic device 101 according to an embodiment of the present disclosure.

Referring to FIG. 1, the electronic device 101 may include a battery module 110, a sensor circuit 120, a communication circuit 130, a memory 140, and a processor 150. According to an embodiment, at least one component (e.g., the battery module 110) of the electronic device 101 shown in FIG. 1 may be replaced with another component (e.g., a battery pack including a plurality of battery modules 110). According to an embodiment, at least one component (e.g., the battery module 110) of the electronic device 101 shown in FIG. 1 may be provided in plural. According to an embodiment, at least one component (e.g., the sensor circuit 120 or the communication circuit 130) of the electronic device 101 shown in FIG. 1 may be excluded from the electronic device 101. According to an embodiment, the electronic device 101 may further include at least one component (e.g., a power unit (e.g., a motor), a display, an input device, or an output device) in addition to components shown in FIG. 1.

In an embodiment, the electronic device 101 may be a battery management system (BMS). When the electronic device 101 is implemented with a BMS, the electronic device 101 may supply power of the battery module 110 to an external component (e.g., a motor).

In an embodiment, the electronic device 101 may be a battery swapping station (BSS). When the electronic device 101 is implemented with a battery swapping station, the electronic device 101 may include a plurality of slots for storing and/or charging the plurality of battery modules 110.

In an embodiment, the battery module 110 may supply power to one or more components of the electric device 101. In an embodiment, the battery module 110 may be attached to or detached from the electronic device 101.

In an embodiment, the battery module 110 may include one or more battery cells 111, 113, or 115. The one or more battery cells 111, 113, or 115 may be included in a state of being electrically connected to one another in the battery module 110. For example, the one or more battery cells 111, 113, and 115 may be connected to one another in series and/or in parallel. According to an embodiment, the one or more battery cells 111, 113, or 115 may be included in a state of being electrically separated from one another in the battery module 110.

In an embodiment, the sensor circuit 120 may obtain information related to the battery module 110. In an embodiment, the sensor circuit 120 may obtain values (or information) related to respective states of the one or more battery cells 111, 113, or 115. In an embodiment, the values related to the states may include one or more values of voltages, currents, resistances, SoC, SoH, or temperatures of a battery cell or combinations thereof. Hereinbelow, the value related to the state may be referred to as a 'state value'.

In an embodiment, the sensor circuit 120 may provide information (e.g., state values) of the one or more battery cells 111, 113, or 115 to the processor 150.

In an embodiment, the communication circuit 130 may establish a wired communication channel or a wireless communication channel between the electronic device 101 and an external electronic device 102, and transmit and receive data to and from the external electronic device 102 through the established communication channel.

In an embodiment, the communication circuit 130 may perform communication based on at least one radio access technology (RAT). In an embodiment, the communication circuit 130 may transmit and receive data to and from the external electronic device 102 by using at least one RAT.

In an embodiment, the memory 140 may include a volatile and/or a nonvolatile memory.

In an embodiment, the memory 140 may store data used by at least one component (e.g., the processor 150 or the sensor circuit 120) of the electronic device 101. For example, the data may include software (or an instruction related thereto), input data, or output data. In an embodiment, an instruction, when executed by the processor 150, may cause the electronic device 101 to perform operations defined by the instruction.

In an embodiment, the processor 150 may execute software to control at least one other component (e.g., a hardware or software component) of the electronic device 101 connected to the processor 150 and may process or compute various data.

Hereinbelow, a description will be made of a method in which the electronic device 101 according to an embodiment of the present disclosure determines abnormality of the one or more battery cells 111, 113, or 115 included in the battery module 110.

In an embodiment, the electronic device 101 may obtain state values (e.g., one or more values related to voltage, current, resistance, charge state, health state, or temperature) of the one or more battery cells 111, 113, or 115. In an embodiment, the electronic device 101 may obtain state values of the one or more battery cells 111, 113, or 115 for a designated time window (e.g., 180 seconds (sec)). In an embodiment, the electronic device 101 may obtain state values of the one or more battery cells 111, 113, or 115 at designated time intervals (e.g., 0.1 second) for a designated time window (e.g., 180 seconds (sec)). For example, the electronic device 101 may obtain voltage values of the one or more battery cells 111, 113, or 115. In another example, the electronic device 101 may obtain current values of the one or more battery cells 111, 113, or 115.

In an embodiment, the electronic device 101 may obtain state values of a battery cell while the battery cell satisfies a designated condition. In an embodiment, the designated condition of the battery cell may refer to a state of the battery cell being charged. In an embodiment, the designated state of the battery cell may mean a state in which a voltage (e.g., an open circuit voltage (OCV)) of the battery cell is within a designated voltage range (e.g., 3.9 to 4.1 volts) while the battery cell is being charged.

Hereinbelow, the state values of the one or more battery cells 111, 113, or 115 may be designated as 'input data'. In an embodiment, the input data may be expressed as a matrix (e.g., an M x N matrix) including N values of M battery cells 111, 113, or 115. For example, the input data may include N voltage values of the M battery cells 111, 113, or 115. In another example, the input data may include one of N current, resistance, charge state, health state, or temperature values of the M battery cells 111, 113, or 115. Herein, M may indicate the number of battery cells 111, 113, or 115, and N may correspond to a value obtained by dividing a designated time window by a designated time interval. For example, when the number of battery cells 111, 113, or 115 is 100, a designated time window is 180 seconds, and a designated time interval is 0.1 second, M may be 100 and N may be 1800.

For example, input data $D_{input}$ may be expressed as Equation 1.

[Equation 1]

$$D_{input} = \begin{pmatrix} v_{1,1} & \cdots & v_{1,N} \\ \vdots & \ddots & \vdots \\ v_{M,1} & \cdots & v_{M,N} \end{pmatrix}$$

In Equation 1, respective entries $v_{1,1}$, $v_{1,N}$, $v_{M,1}$, and $v_{M,N}$ of the input data $D_{input}$ may indicate the state values of the battery cells 111, 113, or 115. Respective columns (or column vectors) of the input data $D_{input}$ may indicate M state values obtained at the same time point (or a sensing time of the sensor circuit 120). Respective rows (or row vectors) of the input data $D_{input}$ may indicate N state values respectively obtained from the battery cells 111, 113, or 115 for a designated time window. For example, the entries $v_{1,1}$ and $v_{M,1}$ of the first column vector may be state values of the battery cells 111, 113, or 115 obtained at the first time point. The entries $v_{1,1}$ and $v_{M,1}$ of the first row vector may be state values obtained from the first battery cell for a designated time window. In an embodiment, the respective entries $v_{1,1}$, $v_{1,N}$, $v_{M,1}$, and $v_{M,N}$ of the input data $D_{input}$ may indicate the state values of the same type. For example, the entries $v_{1,1}$, $v_{1,N}$, $v_{M,1}$, and $v_{M,N}$ may indicate state values of one type of current, resistance, charge state, health state, or temperature.

In an embodiment, the electronic device 101 may obtain feature data based on input data. In an embodiment, the electronic device 101 may obtain feature data from the input data based on a designated decomposition algorithm. In an embodiment, the designated decomposition algorithm may be based on matrix decomposition. In an embodiment, the designated decomposition algorithm may be based on singular value decomposition (SVD). In an embodiment, the designated decomposition algorithm may be based on eigenvalue decomposition and/or principal component analysis (PCA).

In an embodiment, the electronic device 101 may perform SVD on the input data. For example, when input data including N values of each of the M battery cells 111, 113, or 115 is an M x N matrix $D_{input}$, the input data may be singular-value-decomposed as in Equation 2 below.

[Equation 2]

$$D_{input} = U \times S \times V^T$$

In Equation 2, U is an M x M unitary matrix, S is an M x N diagonal matrix including diagonal components having values of 0 or greater and components other than the diagonal components having values of 0, and $V^T$ is an N x N unitary matrix. In an embodiment, when M is less than N, the matrix S of the input data may be expressed as Equation 3 below.

[Equation 3]

$$S = \begin{pmatrix} s_{1,1} & 0 & \cdots & 0 & \cdots & 0 \\ 0 & s_{2,2} & \cdots & 0 & \cdots & 0 \\ \vdots & \vdots & \ddots & 0 & \cdots & 0 \\ 0 & 0 & 0 & s_{M,M} & \cdots & 0 \end{pmatrix}$$

In Equation 3, the values of the other components than the diagonal components $s_{1,1}$, $s_{2,2}$, and $s_{M,M}$ of the matrix S may be 0. In the diagonal components $s_{1,1}$, $s_{2,2}$, and $s_{M,M}$, higher value diagonal components may have lower row indices and lower column indices.

In an embodiment, the electronic device 101 may classify diagonal components (or singular values) based on the matrix S of the input data. In an embodiment, the electronic device 101 may classify L diagonal components included in the matrix S into major diagonal components or minor diagonal components. In an embodiment, the electronic device 101 may classify k diagonal components as major diagonal components in a descending order of values among L diagonal components. In an embodiment, the electronic device 101 may classify p diagonal components as minor diagonal components in an ascending order of values among the L diagonal components. Herein, L is a less value between M and N, and a sum of k and p is L. Herein, k diagonal components may be diagonal components for obtaining common data from input data, and p diagonal components may be diagonal components for obtaining feature data from the input data.

In an embodiment, k and p may be determined based on an occupancy (or ratio) of diagonal components. In an embodiment, the occupancy may be a ratio of a sum of the values of the designated diagonal components to a sum of the values of the L diagonal components. The occupancy of the major diagonal components may be determined based on Equation 4 below.

[Equation 4]

$$r(k) = \frac{\sum_{i=1}^{k} s_{i,i}}{\sum_{j=1}^{L} s_{j,j}}$$

In Equation 4, L is a less value between M and N, $s_{i,i}$ is a value of an $i^{th}$ diagonal component (singular value), $s_{j,j}$ is a value of a $j^{th}$ diagonal component (singular value), and r(k) indicates a ratio of a sum of the values of the k major diagonal components to a sum of the values of the L diagonal components. Herein, for example, M is less than N such that L is M.

In an embodiment, the electronic device 101 may identify the least k which causes r(k) to have a designated occupancy (e.g., 0.998) or greater. In an embodiment, the occupancy may be changed based on a situation of obtaining input data. For example, when the input data is less than a lower limit of the designated voltage range (e.g., 3.9 to 4.1 volts), a greater occupancy than an occupancy (e.g., 0.998) set in the designated voltage range may be set.

In another embodiment, the electronic device 101 may obtain the number k of diagonal components (or singular values) satisfying a designated condition based on a magnitude of N or M. For example, the electronic device 101 may identify k corresponding to a rounded-up value, a rounded-down value, or a rounded value of a product of the less value between N or M and a ratio value (e.g., 0.98).

In an embodiment, the electronic device 101 may obtain feature data. In an embodiment, the electronic device 101 may obtain feature data based on the identified k. The feature data may be obtained based on Equation 5 below.

[Equation 5]

$$D_{feature} = U \times S_{feature} \times V^{T}$$

In Equation 5, U is an M x M unitary matrix of Equation 1, $V^{T}$ is an N x N unitary matrix of Equation 1, and $S_{feature}$ is an M x N diagonal matrix in which in S of Equation 1, first to $k^{th}$ diagonal components (i.e., major diagonal components) are substituted by 0 (or components other than $p^{th}$ to $L^{th}$ diagonal components have values of 0). Herein, $S_{feature}$ may be referred to as a feature matrix. According to an embodiment, common data $D_{common}$ may be data excluding feature data $D_{features}$ from the input data $D_{input}$.

In an embodiment, the electronic device 101 may analyze the feature data.

In an embodiment, the electronic device 101 may obtain standardized data based on feature components included in the feature data. In an embodiment, the electronic device 101 may identify standardized scores of feature components of each of one or more battery cells 111, 113, or 115 included in the feature data. In an embodiment, the feature components of each of the one or more battery cells 111, 113, or 115 may be N components included in the corresponding row among M rows of the feature data $D_{features}$ that is an M x N matrix. For example, the feature components of the first cell may be N components of the first row of the feature data $D_{features}$.

In an embodiment, standardization may transform values into standardized scores (or Z scores). For example, standardization may be based on Equation 6 below.

[Equation 6]

$$z_{feature,i,j} = \frac{D_{feature,i,j} - m_{feature,j}}{\sigma_{feature,j}}$$

In Equation 6, $z_{feature, i, j}$ indicates a standardized score of a $j^{th}$ entry of an $i^{th}$ row vector of the feature data. $D_{feature, i, j}$ indicates a value of the $j^{th}$ entry of the $i^{th}$ row vector of the feature data. $m_{feature, j}$ indicates an average of entries of a $j^{th}$ column vector of the feature data. $\sigma_{feature,j}$ indicates an average deviation of entries of the $j^{th}$ column vector of the feature data. Herein, i indicates an integer of 1 or greater and less than or equal to the number of rows of the feature data, and j indicates an integer of 1 or greater and less than or equal to the number of columns of the feature data.

In an embodiment, the electronic device 101 may obtain feature values of the one or more battery cells 111, 113, or 115 based on standardized scores of each of the one or more battery cells 111, 113, or 115. In an embodiment, the feature value may be obtained based on a maximum value, a minimum value, an average value, a median value, a deviation, a standard deviation of standardized scores, or a combination thereof. In an embodiment, the feature value may be obtained based on a value obtained by subtracting a minimum value from a maximum value of standardized scores. In an embodiment, the feature value may be obtained based on Equation 7.

[Equation 7]

$$v_{feature,i} = z_{max,i} - z_{min,i}$$

In Equation 7, $v_{feature, i}$ is a feature value of an $i^{th}$ row vector of standardized data, $z_{max, i}$ is a maximum value of standardized scores of the $i^{th}$ row vector of the standardized data, and $z_{min, i}$ is a minimum value of standardized scores of the $i^{th}$ row vector of the standardized data.

In an embodiment, the electronic device 101 may identify abnormality of each of the one or more battery cells 111, 113, or 115 based on a result of analyzing the feature data.

In an embodiment, the electronic device 101 may identify that abnormality occurs in a battery cell having a feature value exceeding a designated reference feature value among the one or more battery cells 111, 113, or 115. In an embodiment, the electronic device 101 may identify that abnormality occurs in a battery cell having the highest feature value among the one or more battery cells 111, 113, or 115. In an embodiment, the electronic device 101 may identify that abnormality occurs in a battery cell having the lowest feature value among the one or more battery cells 111, 113, or 115. In an embodiment, the electronic device 101 may identify that abnormality occurs in a battery cell having a feature value less than the designated reference feature value among the one or more battery cells 111, 113, or 115. In an embodiment, the electronic device 101 may identify that abnormality occurs in a battery cell having a feature value falling beyond a designated reference feature value range among the one or more battery cells 111, 113, or 115. In an embodiment, the reference feature value may be a value for determining abnormality of a battery cell. In an embodiment, the reference feature value may be determined experimentally.

In an embodiment, the electronic device 101 may provide a notification to a user through an output device (or a display) when a battery cell including abnormality is identified. In an embodiment, the notification provided to the user may include a notification to check abnormality of a battery cell, a notification to replace a battery cell, or a combination thereof.

According to an embodiment, the number of one or more battery cells 111, 113, or 115 may not be sufficient to identify abnormality of a battery cell based on the decomposition algorithm. Hereinbelow, a description will be made of a method for configuring input data to obtain effective feature data by the electronic device 101 according to an embodiment of the present disclosure in a situation where the number of one or more battery cells 111, 113, or 115 is limited.

In an embodiment, the electronic device 101 may store state values of each of the one or more battery cells 111, 113, or 115, obtained through the sensor circuit 120, in the memory 140. In an embodiment, the electronic device 101 may store state values of each of the one or more battery cells 111, 113, or 115 in the memory 140 in the unit of a designated time window. For example, the electronic device 101 may store state values obtained for a first time window in the memory 140, and store state values obtained for a second time window in the memory 140. Herein, the second time window may at least partially overlap the first time window or may not overlap the first time window.

In an embodiment, the electronic device 101 may obtain additional input data from state values previously obtained and stored in the memory 140. In an embodiment, the additional input data may include the previously obtained state values of the one or more battery cells 111, 113, or 115. Herein, the additional input data may be data having the same obtaining environment as the obtaining environment of the current input data.

In an embodiment, the obtaining environment may mean a condition of voltage, current, resistance, charge state, health state, or temperature while the input data is obtained.

In an embodiment, the electronic device 101 may obtain additional input data where at least one of one or more elements indicating the obtaining environment is the same as and/or similar with the current input data. For example, when the current input data is obtained in a state where the battery cell has a designated voltage range (e.g., 3.9 to 4.1 volts) during charging of the battery cell, the electronic device 101 may obtain additional input data from information stored in the memory 140 based on state values obtained in a state where the battery cell has the designated voltage range (or a voltage range including the designated voltage range) during charging of the battery cell.

In an embodiment, the electronic device 101 may configure new input data (e.g., M x N matrix data) with the input data and the additional input data. In an embodiment, the electronic device 101 may obtain feature data based on the new input data.

According to an embodiment, the electronic device 101 may transmit input data and/or information indicating an obtaining environment of the input data to the external electronic device 102 by using the communication circuit 130. In an embodiment, the electronic device 101 may obtain additional input data corresponding to the input data and/or the information indicating the obtaining environment of the input data from the external electronic device 102. In an embodiment, the electronic device 101 may obtain feature data based on the input data and the additional input data obtained from the external electronic device 102. In an embodiment, the additional input data from the external electronic device 102 may include state values of other cells than the one or more battery cells 111, 113, or 115.

According to an embodiment, at least some of operations for the electronic device 101 to determine abnormality of the one or more battery cells 111, 113, or 115 included in the battery module 110 may be performed by the external electronic device 102. For example, when the electronic device 101 transmits the input data to the external electronic device 102, the external electronic device 102 may obtain the feature data based on the input data, identify abnormality of each of the one or more battery cells 111, 113, or 115 based on the feature data, and provide a result of identifying abnormality to the electronic device 101.

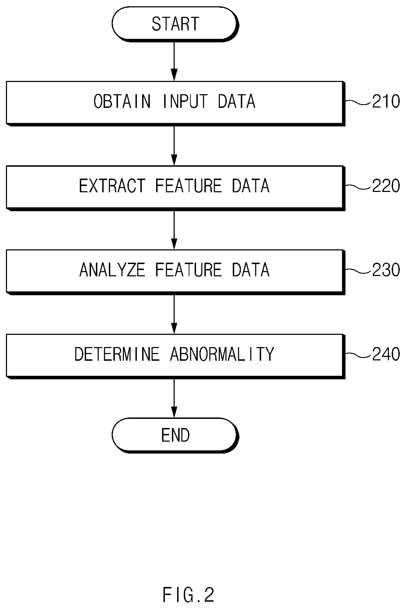

FIG. 2 is a flowchart illustrating operations of the electronic device 101 according to an embodiment of the present disclosure.

Referring to FIG. 2, in operation 210, the electronic device 101 may obtain input data. The electronic device 101 may obtain state values (e.g., voltage, current, resistance, charge state, health state, or temperature) of each of the one or more battery cells 111, 113, or 115, as input data. In an embodiment, the electronic device 101 may obtain, as input data, state values of the one or more battery cells 111, 113, or 115 obtained at designated time intervals (e.g., 0.1 second) for a designated time window. In an embodiment, the electronic device 101 may obtain, as input data, state values of a battery cell, obtained while the battery cell has a designated state.

In an embodiment, the electronic device 101 may use the additional input data, as the input data, from the information previously obtained and stored in the memory 140. In an embodiment, the electronic device 101 may use, as the input data, the additional input data obtained from the external electronic device 102 using the communication circuit 130.

In operation 220, the electronic device 101 may extract the feature data. In an embodiment, the electronic device 101 may extract (or obtain) the feature data from the input data based on a designated decomposition algorithm. In an embodiment, the designated decomposition algorithm may be based on SVD, eigenvalue decomposition and/or PCA.

For example, the electronic device 101 may perform SVD on the input data. Thereafter, the electronic device 101 may classify diagonal components (or singular values) based on the matrix S of the singular-value-decomposed input data. The electronic device 101 may extract the feature data $D_{features}$ from the input data $D_{input}$ based on the minor diagonal components.

In operation 230, the electronic device 101 may analyze the feature data. The electronic device 101 may identify feature components of each of one or more battery cells 111, 113, or 115 included in the feature data. In an embodiment, the electronic device 101 may obtain feature values of the one or more battery cells 111, 113, or 115 based on feature components of each of the one or more battery cells 111, 113, or 115. For example, the electronic device 101 may obtain standardized data based on the feature components included in the feature data and obtain feature values of the one or more battery cells 111, 113, or 115 based on standardized scores of each of the one or more battery cells 111, 113, or 115.

In operation 240, the electronic device 101 may determine abnormality. In an embodiment, the electronic device 101 may identify that abnormality occurs in a battery cell having a feature value exceeding a designated reference feature value among the one or more battery cells 111, 113, or 115. In an embodiment, the electronic device 101 may identify that abnormality occurs in a battery cell having a feature value less than the designated reference feature value among the one or more battery cells 111, 113, or 115. In an embodiment, the electronic device 101 may identify that abnormality occurs in a battery cell having a feature value falling beyond a designated reference feature value range among the one or more battery cells 111, 113, or 115.

Thereafter, the electronic device 101 may provide a notification to a user through an output device (or a display) when a battery cell including abnormality is identified. In an embodiment, the notification provided to the user may include a notification to check abnormality of a battery cell, a notification to replace a battery cell, or a combination thereof.

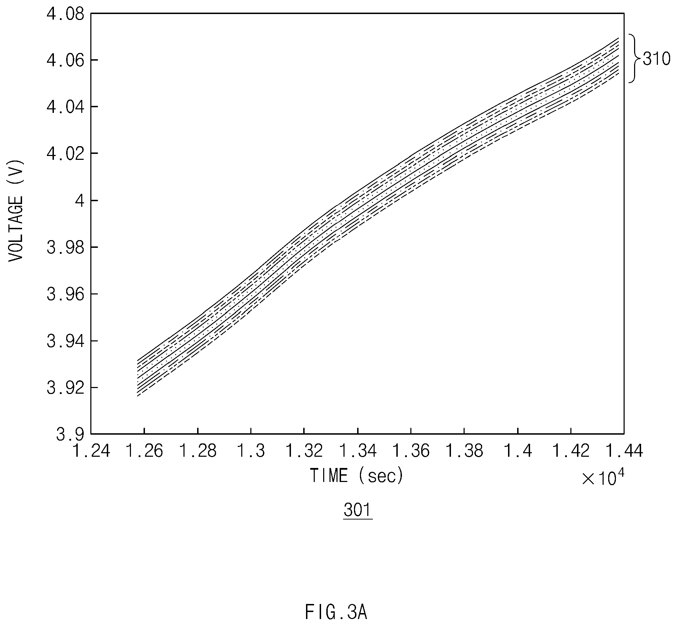

FIG. 3A illustrates a graph 301 according to an embodiment of the present disclosure. Referring to FIG. 3A, it may be seen that input data 310 is obtained for about 180 seconds (1440 - 1260 seconds). The input data 310 may be obtained in a designated voltage range (e.g., 3.9 to 4.1 volts) of battery cells.

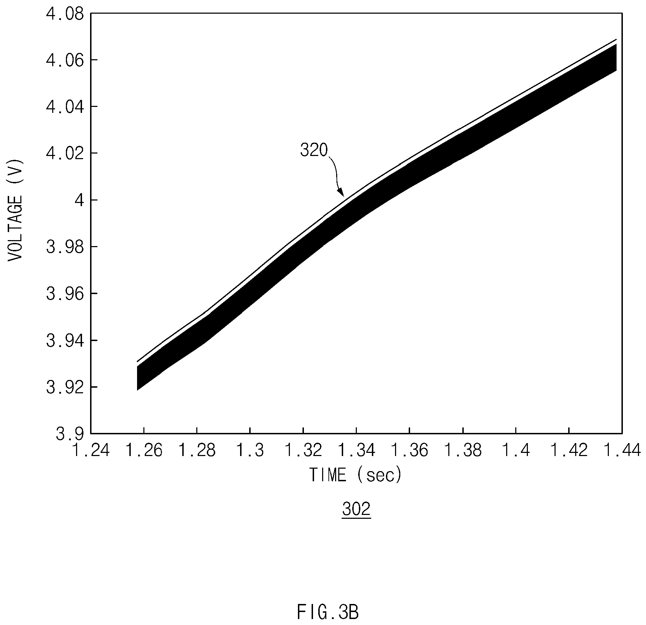

FIG. 3B illustrates a graph 302 according to an embodiment of the disclosure. Data 320 shown in the graph 302 may indicate the common data $D_{common}$ obtained by performing SVD on the input data 310.

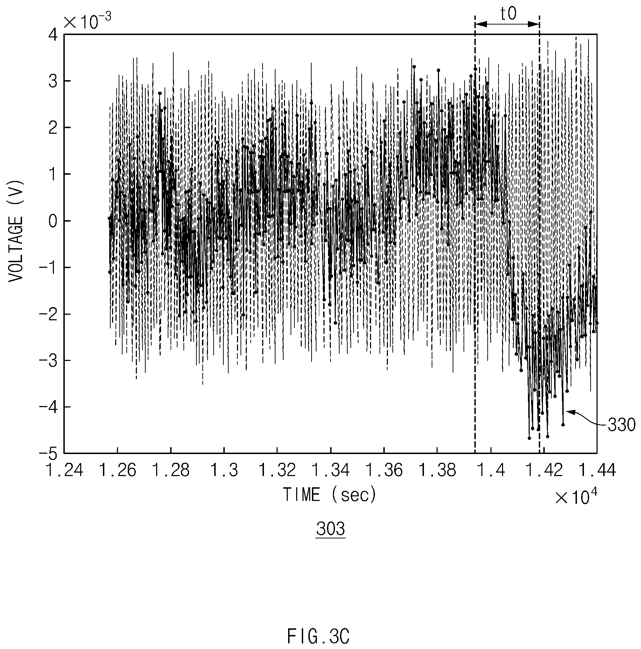

FIG. 3C illustrates a graph 303 according to an embodiment of the present invention. Data shown in the graph 303 may indicate the feature data $D_{features}$ obtained by performing SVD on the input data 310. The input data 310 of FIG. 3A may be the same as a sum of the common data $D_{common}$ and the feature data $D_{features}$.

Referring to FIG. 3C, it may be seen that a voltage value 330 of a specific battery cell of FIG. 3C changes in a specific time range t0. As the voltage value 330 exceeds a designated reference value, a feature value of the corresponding battery cell may exceed the reference feature value (e.g., 4).

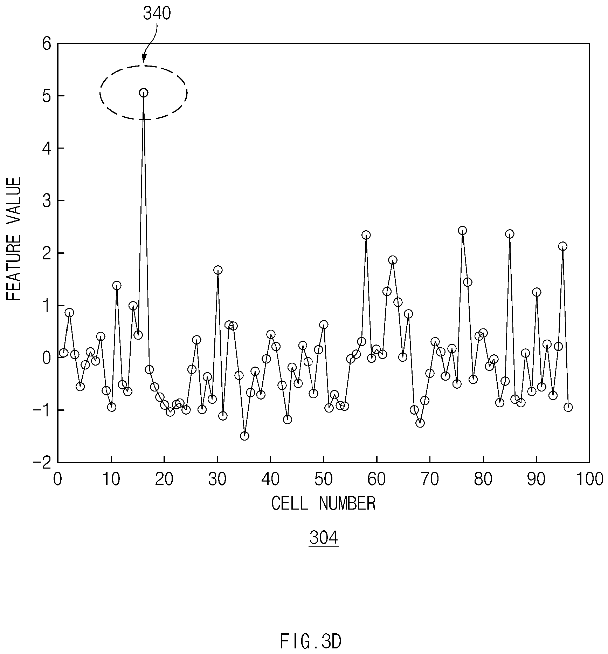

FIG. 3D illustrates a graph 304 according to an embodiment of the present disclosure. Feature values shown in the graph 304 may be feature values of respective battery cells.

Referring to FIG. 3D, as the voltage value 330 of FIG. 3C exceeds the designated reference value, a feature value 340 of the corresponding battery cell may be exceeding the reference feature value (e.g., 4). Thus, the corresponding battery cell may be determined as being in an abnormal state.

**Claims**

1. An electronic device (101) comprising:

   a battery module (110) comprising a plurality of battery cells;
   a sensor circuit (120) configured to obtain state values of each of the plurality of battery cells; and
   a processor (150),
   the processor being configured to:

   obtain values related to states of each of the plurality of cells as input data through the sensor circuit;
   obtain feature data based on a feature matrix derived from the input data by using a designated matrix decomposition algorithm; and
   identify whether each of the plurality of cells is abnormal, based on the feature data,
   wherein the feature matrix is a matrix where values of a designated number of major diagonal components among a plurality of diagonal components of a diagonal matrix for the input data are substituted by 0.

2. The electronic device of claim 1, wherein the designated number is a minimum number that causes an occupancy of the major diagonal components with respect to a sum of the plurality of diagonal components exceeds a designated value or greater.

3. The electronic device of claim 1, wherein the input data is obtained in a designated range of a measurement item, and

   the measurement item comprises at least one of voltage, current, resistance, state of charge, SoC, state of health SoH, or temperature.

4. The electronic device of claim 3, wherein when the measurement item is voltage, the designated range is between 3.9 and 4.1 volts.

5. The electronic device of claim 3, wherein the input data is obtained at designated time intervals for a designated time window while the battery module is being charged.

6. The electronic device of claim 1, wherein the processor is further configured to:

   identify additional input data based on the input data; and
   obtain the feature data based on the input data and the additional input data.

7. The electronic device of claim 6, wherein the additional input data comprises state values of other cells than the plurality of cells.

8. The electronic device of claim 6, wherein the additional input data comprises previously obtained state values of the plurality of cells.

9. The electronic device of claim 1, wherein the processor is further configured to:

   obtain a feature value of each of the plurality of cells based on feature components of each of the plurality of cells included in the feature data; and
   identify a cell having a feature value exceeding a designated reference feature value among the plurality of cells.

10. The electronic device of claim 1, further comprising a display,
    wherein the processor is further configured to provide user notification through the display in response to at least one of the plurality of cells being identified as being in an abnormal state.

11. An operating method of an electronic device, the operating method comprising:

obtaining (210) values related to states of each of a plurality of cells of the electronic device as input data through a sensor circuit of the electronic device;

obtaining (220) feature data based on a feature matrix derived from the input data by using a designated matrix decomposition algorithm; and

identifying (230, 240) whether each of the plurality of cells is abnormal, based on the feature data,

wherein the feature matrix is a matrix where values of a designated number of major diagonal components among a plurality of diagonal components of a diagonal matrix for the input data are substituted by 0.

12. The operating method of claim 11, wherein the designated number is a minimum number that causes an occupancy of the major diagonal components with respect to a sum of the plurality of diagonal components exceeds a designated value.

13. The operating method of claim 11, wherein the obtaining of the feature data comprises:

identifying reference input data based on the input data; and

obtaining the feature data based on the input data and the reference input data.

14. The operating method of claim 13, wherein the reference input data indicates information related to states of other cells than the plurality of cells.

15. The operating method of claim 11, wherein the identifying of whether each of the plurality of batteries is abnormal comprises:

obtaining a feature value of each of the plurality of cells based on feature components of each of the plurality of cells included in the feature data; and

identifying a cell having a feature value exceeding a designated reference feature value among the plurality of cells.

## Patentansprüche

1. Elektronische Vorrichtung (101) aufweisend:

ein Batteriemodul (110) aufweisend mehrere Batteriezellen;

eine Sensorschaltung (120), die konfiguriert ist, Zustandswerte von jeder der mehreren Batteriezellen zu erhalten; und

einen Prozessor (150), wobei der Prozessor konfiguriert ist:

Werte, die sich auf Zustände von jeder der mehreren Zellen beziehen, als Eingangsdaten durch die Sensorschaltung zu erhalten;

Merkmalsdaten basierend auf einer Merkmalsmatrix zu erhalten, die von den Eingangsdaten unter Verwendung eines designierten Matrixzerlegungsalgorithmus abgeleitet ist; und

basierend auf den Merkmalsdaten zu identifizieren, ob jede der mehreren Zellen anormal ist,

wobei die Merkmalsmatrix eine Matrix ist, in der Werte einer designierten Anzahl von Hauptdiagonalkomponenten unter mehreren Diagonalkomponenten einer Diagonalmatrix für die Eingangsdaten durch o ersetzt sind.

2. Elektronische Vorrichtung nach Anspruch 1, wobei die designierte Anzahl eine Mindestanzahl ist, die bewirkt, dass eine Belegung der Hauptdiagonalkomponenten in Bezug auf eine Summe der mehreren Diagonalkomponenten einen designierten Wert oder mehr überschreitet.

3. Elektronische Vorrichtung nach Anspruch 1, wobei die Eingangsdaten in einem designierten Bereich eines Messelements erhalten werden, und das Messelement Spannung und/oder Strom und/oder Widerstand und/oder Ladezustand und/oder SoC und/oder Gesundheitszustand und/oder SoH und/oder Temperatur aufweist.

4. Elektronische Vorrichtung nach Anspruch 3, wobei, wenn das Messelement Spannung ist, der designierte Bereich zwischen 3,9 und 4,1 Volt liegt.

5. Elektronische Vorrichtung nach Anspruch 3, wobei die Eingangsdaten in designierten Zeitintervallen für ein designiertes Zeitfenster erhalten werden, während das Batteriemodul geladen wird.

6. Elektronische Vorrichtung nach Anspruch 1, wobei der Prozessor ferner konfiguriert ist:

zusätzliche Eingangsdaten basierend auf den Eingangsdaten zu identifizieren; und

die Merkmalsdaten basierend auf den Eingangsdaten und den zusätzlichen Eingangsdaten zu erhalten.

**7.** Elektronische Vorrichtung nach Anspruch 6, wobei die zusätzlichen Eingangsdaten Zustandswerte von anderen Zellen als den mehreren Zellen aufweisen.

**8.** Elektronische Vorrichtung nach Anspruch 6, wobei die zusätzlichen Eingangsdaten zuvor erhaltene Zustandswerte der mehreren Zellen aufweisen.

**9.** Elektronische Vorrichtung nach Anspruch 1, wobei der Prozessor ferner konfiguriert ist:

einen Merkmalswert jeder der mehreren Zellen basierend auf Merkmalskomponenten jeder der mehreren Zellen zu erhalten, die in den Merkmalsdaten enthalten sind; und
eine Zelle mit einem Merkmalswert zu identifizieren, der einen designierten Referenzmerkmalswert unter den mehreren Zellen überschreitet.

**10.** Elektronische Vorrichtung nach Anspruch 1, ferner aufweisend eine Anzeige,
wobei der Prozessor ferner konfiguriert ist, eine Benutzerbenachrichtigung durch die Anzeige als Reaktion darauf bereitzustellen, dass mindestens eine der mehreren Zellen als in einem anormalen Zustand befindlich identifiziert wird.

**11.** Betriebsverfahren einer elektronischen Vorrichtung, wobei das Betriebsverfahren aufweist:

Erhalten (210) von Werten, die sich auf Zustände von jeder von mehreren Zellen der elektronischen Vorrichtung beziehen, als Eingangsdaten durch eine Sensorschaltung der elektronischen Vorrichtung;
Erhalten (220) von Merkmalsdaten basierend auf einer Merkmalsmatrix, die von den Eingangsdaten unter Verwendung eines designierten Matrixzerlegungsalgorithmus abgeleitet ist; und
Identifizieren (230, 240), ob jede der mehreren Zellen anormal ist, basierend auf den Merkmalsdaten,
wobei die Merkmalsmatrix eine Matrix ist, in der Werte einer designierten Anzahl von Hauptdiagonalkomponenten unter mehreren Diagonalkomponenten einer Diagonalmatrix für die Eingangsdaten durch o ersetzt sind.

**12.** Betriebsverfahren nach Anspruch 11, wobei die designierte Anzahl eine Mindestanzahl ist, die bewirkt, dass eine Belegung der Hauptdiagonalkomponenten in Bezug auf eine Summe der mehreren Diagonalkomponenten einen designierten Wert überschreitet.

**13.** Betriebsverfahren nach Anspruch 11, wobei das Erhalten der Merkmalsdaten aufweist:

Identifizieren von Referenzeingangsdaten basierend auf den Eingangsdaten; und
Erhalten der Merkmalsdaten basierend auf den Eingangsdaten und den Referenzeingangsdaten.

**14.** Betriebsverfahren nach Anspruch 13, wobei die Referenzeingangsdaten Informationen in Bezug auf Zustände anderer Zellen als der mehreren Zellen angeben.

**15.** Betriebsverfahren nach Anspruch 11, wobei das Identifizieren, ob jede der mehreren Batterien anormal ist, aufweist:

Erhalten eines Merkmalswerts jeder der mehreren Zellen basierend auf Merkmalskomponenten jeder der mehreren Zellen, die in den Merkmalsdaten enthalten sind; und
Identifizieren einer Zelle mit einem Merkmalswert, der einen designierten Referenzmerkmalswert unter den mehreren Zellen überschreitet.

**Revendications**

**1.** Dispositif électronique (101) comprenant :

un module de batterie (110) comprenant une pluralité d'éléments de batterie ;
un circuit de détection (120) configuré pour obtenir des valeurs d'état de chacune de la pluralité d'éléments de batterie ; et
un processeur (150),
le processeur étant configuré pour :

obtenir des valeurs relatives à des états de chacun de la pluralité d'éléments en tant que données entrées par le biais du circuit de détection ;
obtenir des données caractéristiques basées sur une matrice de caractéristiques dérivée des données entrées, en utilisant un algorithme de décomposition de matrice désigné ; et
établir si chacun de la pluralité d'éléments est anormal, d'après les données caractéristiques,
la matrice de caractéristiques étant une matrice dans laquelle des valeurs d'un nombre désigné de composants diagonaux principaux, parmi une pluralité de composants diagonaux d'une matrice diagonale pour les données entrées, sont remplacées par 0.

**2.** Dispositif électronique selon la revendication 1, le nombre désigné étant un nombre minimum, donnant lieu à un taux d'occupation des principaux composants diagonaux relativement à une somme de la pluralité de composants diagonaux dépassant une valeur désignée ou supérieure.

**3.** Dispositif électronique selon la revendication 1, les données entrées étant obtenues dans une plage désignée d'un élément de mesure, et
l'élément de mesure comprenant au moins un des suivants : tension, courant, résistance, état de charge - SoC, état de santé - SoH, ou température.

**4.** Dispositif électronique selon la revendication 3, dans lequel lorsque l'élément de mesure est la tension, la plage désignée est comprise entre 3,9 et 4,1 volts.

**5.** Dispositif électronique selon la revendication 3, les données entrées s'obtenant à des intervalles désignés dans un créneau temporel désigné pendant la charge du module de batterie.

**6.** Dispositif électronique selon la revendication 1, le processeur étant configuré en outre pour :

identifier des données entrées additionnelles d'après les données entrées ; et
obtenir les données caractéristiques d'après les données entrées et les données entrées additionnelles.

**7.** Dispositif électronique selon la revendication 6, les données entrées additionnelles comprenant des valeurs d'état sur des éléments autres que la pluralité d'éléments.

**8.** Dispositif électronique selon la revendication 6, les données entrées additionnelles comprenant des valeurs d'état obtenues précédemment de la pluralité d'éléments.

**9.** Dispositif électronique selon la revendication 1, le processeur étant configuré en outre pour :

obtenir un valeur caractéristique de chacun de la pluralité d'éléments d'après des composantes caractéristiques de chacun de la pluralité d'éléments compris dans les données caractéristiques ; et
identifier un élément dont la valeur caractéristique est supérieure à une valeur caractéristique de référence désignée parmi la pluralité d'éléments.

**10.** Dispositif électronique selon la revendication 1, comprenant en outre un dispositif d'affichage,
le processeur étant configuré en outre pour fournir des notifications d'utilisateur par le biais du dispositif d'affichage, en réponse à au moins un de la pluralité d'éléments identifié comme se trouvant dans un état anormal.

**11.** Procédé d'utilisation d'un dispositif électronique, le procédé d'utilisation comprenant de qui suit :

obtenir (210) des valeurs relatives à des états de chacun de la pluralité d'éléments du dispositif électronique en tant que données entrées par le biais du circuit de détection du dispositif électronique ;
obtenir (220) des données caractéristiques d'après une matrice de caractéristiques dérivée des données entrées, en utilisant un algorithme de décomposition de matrice désigné ; et
établir (230, 240) si chacun de la pluralité d'éléments est anormal, d'après les données caractéristiques,
la matrice de caractéristiques étant une matrice dans laquelle des valeurs d'un nombre désigné de composants diagonaux principaux, parmi une pluralité de composants diagonaux d'une matrice diagonale pour les données entrées, sont remplacées par 0.

**12.** Procédé d'utilisation selon la revendication 11, le nombre désigné étant un nombre minimum, donnant lieu à un taux d'occupation des principaux composants diagonaux relativement à une somme de la pluralité de composants diagonaux dépassant une valeur désignée.

**13.** Procédé d'utilisation selon la revendication 11, l'obtention des données caractéristiques comprenant :

l'identification de données entrées de référence d'après les données entrées ; et
l'obtention des données caractéristiques d'après les données entrées et les données entrées de référence.

**14.** Procédé d'utilisation selon la revendication 13, les données entrées de référence fournissant des informations relatives à l'état d'autres éléments de la pluralité d'éléments.

**15.** Procédé d'utilisation selon la revendication 11, dans lequel établir si chacune de la pluralité de batteries est anormale comporte :

l'obtention d'une valeur caractéristique de chacun de la pluralité d'éléments d'après les composantes caractéristiques de chacun de la pluralité d'éléments compris dans les données caractéristiques ; et
l'identification d'un élément dont la valeur caractéristique est supérieure à une valeur caractéristique de référence désignée parmi la pluralité d'éléments.

ELECTRONIC DEVICE
101

BATTERY MODULE
110

BATTERY CELL
111

BATTERY CELL
113

BATTERY CELL
115

SENSOR CIRCUIT
120

PROCESSOR
150

COMMUNICATION
CIRCUIT
130

MEMORY
140

EXTERNAL
ELECTRONIC
DEVICE
102

FIG.1

EP 4 585 941 B1

```
        ┌─────────────┐
        │    START    │
        └──────┬──────┘
               │
               ▼
   ┌───────────────────────┐
   │   OBTAIN INPUT DATA   │ ～210
   └───────────┬───────────┘
               │
               ▼
   ┌───────────────────────┐
   │   EXTRACT FEATURE DATA│ ～220
   └───────────┬───────────┘
               │
               ▼
   ┌───────────────────────┐
   │   ANALYZE FEATURE DATA│ ～230
   └───────────┬───────────┘
               │
               ▼
   ┌───────────────────────┐
   │  DETERMINE ABNORMALITY│ ～240
   └───────────┬───────────┘
               │
               ▼
        ┌─────────────┐
        │     END     │
        └─────────────┘
```

FIG.2

FIG.3A

FIG.3B

FIG.3C

FIG.3D

**EP 4 585 941 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220113111
- CN 114945834 A